# DEMANDE DE BREVET EUROPEEN

(11) **EP 1 739 840 A1**
(43) Date de publication de la demande: **03.01.2007**
(21) Numéro de dépôt: 06300723.1
(22) Date de dépôt: 23.06.2006
(51) Int. Cl.: H03K 17/965, H01H 3/08, G06F 3/033

(54) **Dispositif de contrôle d'équipements d'un véhicule automobile à dalle tactile acoustique et boutons de contrôle**

(30) Priorité: 28.06.2005 FR 0506556
(71) Demandeur: Peugeot Citroen Automobiles SA, 78943 Vélizy-Villacoublay Cedex (FR)
(72) Inventeur: Lebreton, Etienne, VANVES 92170 (FR); Dessailly, Fabrice, CHAVILLE 92370 (FR); Jarri, Philippe, SONCHAMP 78120 (FR)

(57) **Abrégé**

L'invention concerne un dispositif de contrôle d'équipements d'un véhicule automobile.

Selon l'invention, le dispositif (1) comprend une dalle tactile (3) pourvue d'une surface active (4), dotée d'au moins un capteur (6) relié à une unité de traitement électronique (7) de manière à localiser la provenance d'une onde acoustique à laquelle est soumise une zone (24,25) de la surface active (4) et à contrôler l'équipement (2) associé, et au moins un bouton de contrôle de l'un des équipements (2), pourvu d'une molette (9) montée à rotation autour d'un axe (11) suivant au moins un sens déterminé, et comprenant des dents (12) agissant lors d'une rotation de la molette (9) dans ce sens sur une tête (13) d'un balancier (14) à au moins un bras (16a,16b) solidaire de la tête (13), de manière à faire basculer le balancier (14), à chaque passage d'une dent (12) sur la tête (13), d'une position espacée du bras (16a,16b) de la surface active (4) de la dalle tactile (3) à une position de percussion de l'extrémité libre du bras (16a,16b) sur la surface active (4) pour générer la propagation d'une onde sur cette surface (4).

L'invention trouve application dans le domaine automobile.

## Description

L'invention concerne un dispositif de contrôle et/ou de commande d'équipements d'un véhicule automobile.

Des dispositifs de ce type qui sont connus utilisent des boutons électriques ou électroniques, de type molette et sélecteur multi-positions, généralement regroupés par modules dans l'habitacle du véhicule. Ces boutons peuvent être actionnés sélectivement par un utilisateur pour commander et/ou contrôler un élément d'un équipement du véhicule tel que le volume d'un autoradio, l'éclairage de l'habitacle ou le toit ouvrant du véhicule.

Cependant, cette conception par modules de boutons électriques ou électroniques se traduit par des interfaces complexes entre l'utilisateur et les équipements. En effet, chaque bouton est relié à un dispositif d'actionnement qui lui est propre, destiné à transmettre une information sur son bouton à un circuit électronique. Ainsi, il peut y avoir plusieurs dizaines de boutons dans l'habitacle du véhicule et autant de dispositifs correspondants, ce qui entraîne non seulement une complication des connexions entre les boutons et les dispositifs d'une part, entre les dispositifs et le circuit électronique d'autre part, mais aussi une augmentation du coût et du délai de fabrication d'une façade pourvue de tels modules.

Des recherches dans des domaines relativement éloignés de l'automobile ont été menées pour résoudre le problème de l'utilisation d'une pluralité de boutons électriques ou électroniques, en utilisant une ou plusieurs dalles tactiles.

Chaque dalle tactile est reliée à au moins un capteur et à un dispositif électronique permettant respectivement de capter et de localiser une onde acoustique produite par l'impact d'un élément extérieur, tel qu'un bras de l'utilisateur, sur un emplacement de la surface de la dalle.

Chaque emplacement de la surface de la dalle pouvant être sélectivement sollicité par l'utilisateur peut donc remplacer un bouton et le dispositif associé. La dalle tactile permet ainsi une simplification de l'interface utilisateur - équipements.

Toutefois, l'un des inconvénients de cette technologie réside dans le fait qu'elle est limitée par des contacts d'appui qui certes parviennent à imiter les boutons de type bouton-poussoir mais qui sont inopérants pour copier des boutons de type multi-positions, dont l'utilisateur sélectionne une position particulière.

Ces boutons sont pourtant les plus utilisés dans le domaine du contrôle et/ou de la commande d'équipements d'un véhicule automobile car ils permettent à l'utilisateur de choisir un niveau de puissance et/ou d'ouverture parmi une gamme de niveaux admissibles par un équipement particulier.

Le but de l'invention est de remédier à ces inconvénients en proposant un dispositif de contrôle et/ou de commande d'un ou de plusieurs équipements d'un véhicule automobile, caractérisé en ce qu'il comprend une dalle tactile pourvue d'une surface active, dotée d'au moins un capteur relié à une unité de traitement électronique de manière à localiser la provenance d'une onde acoustique à laquelle est soumise une zone de la surface active et à contrôler et/ou commander l'équipement associé à ladite zone, et comprend au moins un bouton de contrôle et/ou de commande de l'un des équipements, pourvu d'une molette montée à rotation autour d'un axe suivant au moins un sens déterminé, et comprenant des dents agissant lors d'une rotation de la molette dans ce sens sur une tête d'un balancier à au moins un bras solidaire de la tête, de manière à faire basculer le balancier à chaque passage d'une dent sur la tête, d'une position espacée du bras de la surface active de la dalle tactile à une position de percussion de l'extrémité libre du bras sur la surface active pour générer la propagation d'une onde à partir du point d'impact de l'extrémité libre du bras sur cette surface.

Selon une autre caractéristique, le balancier comprend deux bras, solidaires de part et d'autre de la tête en prolongement l'un de l'autre, en étant espacés de la surface active de la dalle, la molette est montée à rotation suivant deux sens opposés de façon que les dents de la molette agissent sur la tête du basculeur pour faire basculer l'un ou l'autre des deux bras selon le sens de rotation de la molette et amener le bras à percuter par son extrémité libre la surface active de la dalle.

Selon encore une autre caractéristique, le balancier est monté pivotant autour d'un axe sensiblement parallèle à la surface active de la dalle tactile.

Avantageusement, l'axe de rotation de la molette est sensiblement perpendiculaire à la surface active de la dalle tactile, la molette est un corps cylindrique creux dont le bord situé en regard de la tête du balancier est découpé de manière à définir les dents contactant la tête du balancier.

Selon un mode préféré de l'invention, la tête du balancier est en forme de prisme à deux faces situées en regard des dents de la molette, inclinées et convergeant vers ces dents de façon que le sommet réunissant ces faces puisse se loger en partie entre deux dents consécutives lors de la rotation de la molette.

Selon une autre caractéristique, chaque bras comporte à son extrémité libre une partie en forme de pointe dirigée vers la surface active de la dalle tactile.

Selon encore une autre caractéristique, le bouton de contrôle et/ou de commande comprend en outre une touche de préhension fixée coaxialement à une extrémité d'une tige, dont l'extrémité opposée est fixée coaxialement à la molette, de manière que la touche et la molette puissent tourner ensemble.

D'autres caractéristiques et avantages de l'invention ressortiront clairement de la description qui en est faite ci-dessous, à titre indicatif et nullement limitatif, en référence aux figures annexées, parmi lesquelles :
- la figure 1 est une vue en perspective du dispositif selon l'invention comportant un bouton de contrôle et/ou de commande associé à une dalle tactile ;
- la figure 2a est une vue en coupe dans le plan contenant la ligne II-II de la figure 1 et perpendiculaire à la dalle tactile et représentant le bouton dans une position inactive ;
- la figure 2b est une vue en coupe semblable à celle de la figure 2a et représentant le bouton dans une position intermédiaire ;
- la figure 2c est une vue en coupe semblable à celle de la figure 2a et représentant le bouton dans une position de percussion de la dalle tactile.

Le dispositif 1 de contrôle et/ou de commande d'équipements 2 de l'invention est destiné à équiper un véhicule automobile au niveau de sa planche de bord ou tout autre emplacement de son habitacle accessible au conducteur et/ou aux passagers du véhicule, désirant contrôler et/ou commander des équipements 2 du véhicule.

À titre d'exemple, l'un des équipements 2 peut être constitué par un autoradio dont on veut contrôler le volume, ou par un toit ouvrant dont on veut commander l'ouverture et la fermeture.

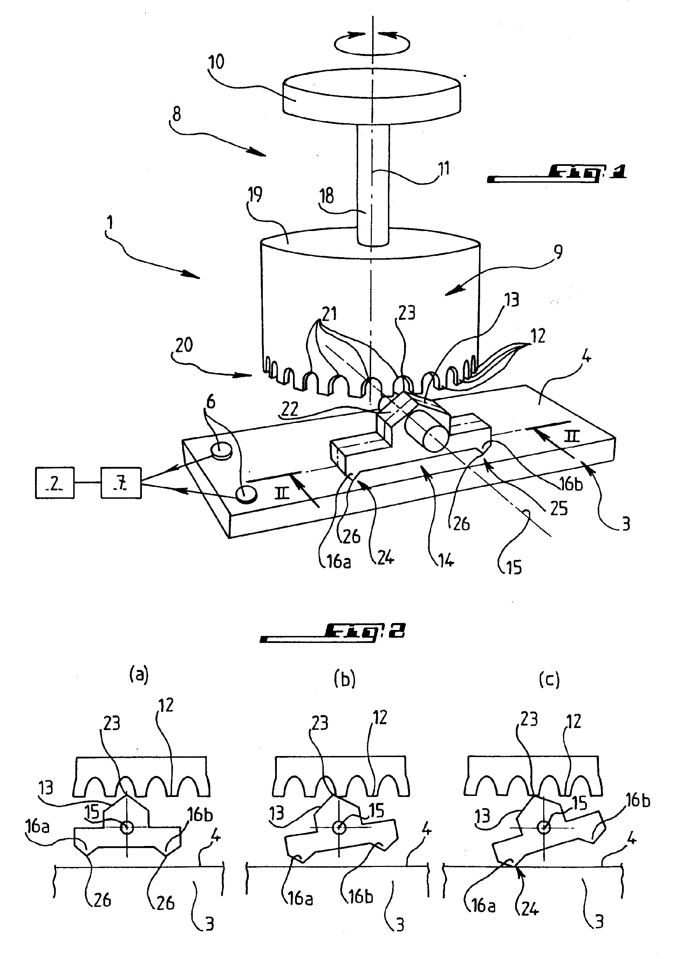

À cet effet, le dispositif 1 comprend une dalle tactile 3 comprenant une surface active 4 et un ou plusieurs capteurs 6, tels que des accéléromètres, en liaison avec une unité de traitement électronique 7 reliée aux équipements 2, comme représenté sur la figure 1. De la sorte, l'unité électronique de traitement 7 permet avec le ou les capteurs 6 de détecter et de localiser une onde de choc acoustique engendrée par un impact sur une zone déterminée de la surface active 4 de la dalle tactile 3 pour contrôler et/ou commander l'équipement 2 associé à cette zone.

Le dispositif 1 comprend au moins un bouton de contrôle et/ou de commande 8 de l'un des équipements 2 du véhicule, pourvu d'une molette 9, actionnable par un utilisateur au moyen d'une touche 10, montée à rotation autour d'un axe 11 sensiblement perpendiculaire à la surface active 4, et comprenant des dents 12 agissant lors d'une rotation de la molette 9 autour de son axe 11 sur une tête 13 d'un balancier 14 monté pivotant autour d'un axe 15 sensiblement parallèle à la surface active 4. Le balancier 14 comprend deux bras 16a,16b, solidaires de la tête 13 et disposés symétriquement de part et d'autre de cette dernière.

Une rotation de la molette 9 amène le passage d'une dent 12 de cette molette 9 sur la tête 13 du balancier 14 qui bascule d'une position d'équilibre inactive, représentée aux figures 1 et 2a, à laquelle les deux bras 16a,16b sont espacés de la surface active 4, à une position de percussion de la surface active 4, représentée en figure 2c, à laquelle l'extrémité libre de l'un des bras 16a,16b percute la surface active 4, générant ainsi la propagation d'une onde à partir du point d'impact.

Plus particulièrement, la touche 10 est fixée à une première extrémité d'une tige 18 sensiblement perpendiculaire à la surface active 4 de la dalle tactile 3, l'autre extrémité de cette tige 18 étant fixée au centre de la paroi supérieure 19 de la molette 9, la touche 10 commandant ainsi les mouvements de rotation de la molette 9.

La molette 9 qui peut tourner autour de l'axe 11 suivant deux sens de rotation opposés, est constituée par un corps cylindrique fermé à son extrémité supérieure par la paroi 19 et dont l'extrémité inférieure est ouverte en regard de la dalle tactile 3. Le bord circulaire 20 de l'extrémité ouverte de la molette 9 est découpé de manière à définir une succession de dents 12 espacées les unes des autres par des creux 21.

La tête 13 du balancier 14 possède avantageusement une forme de prisme à deux faces inclinées 22 convergeant l'une vers l'autre pour former un sommet 23 s'intercalant dans la position d'équilibre du balancier 14 au niveau d'un creux 21 situé entre deux dents consécutives 12. Cette position d'équilibre est atteinte par exemple en prévoyant dans la tête 13 du balancier 14 un ressort en spirales de rappel à cette position.

La mise en rotation de la molette 9 autour de son axe 11, suivant par exemple le sens horaire, déplace l'une des dents 12 le long de la partie supérieure de la face inclinée correspondante de la tête 13 pour provoquer le basculement du balancier 14 autour de son axe de pivotement 15 vers la position de percussion du bras 16a sur une zone 24 de la surface active 4.

Le déplacement subséquent de la dent 12 de la molette 9 au-delà du sommet 23 du balancier 14, dégage la tête 13 du balancier 14 qui pivote autour de son axe 15 pour atteindre de nouveau une position d'équilibre dans le creux 21 suivant.

Par conséquent, la rotation continue de la molette 9 dans ce même sens de rotation provoque le basculement répétitif du balancier 14 entre sa position d'équilibre et sa position de percussion de la surface 4, générant une série d'ondes acoustiques nettes et distinctes se propageant à partir de la zone sous-jacente 24. L'unité de traitement 7 est alors adaptée pour compter le nombre d'impacts générés sur cette zone 24 et pour appliquer la variation appropriée au contrôle et/ou à la commande associée à cette dernière.

Lorsque la molette 9 est actionnée dans l'autre sens de rotation, le basculeur 14 pivote de sorte que son bras 16b percute la surface 4 de la dalle tactile 3 en une zone 25 distincte de la zone 24 précitée.

Il est ainsi intéressant d'associer aux deux zones 24,25 percutables respectivement par les bras 16a,16b du balancier 14, deux contrôles et/ou deux commandes contraires, tels que l'augmentation et la diminution du volume d'un autoradio ou l'ouverture et la fermeture du toit ouvrant.

De préférence, l'extrémité de chaque bras 16a,16b du balancier 14 est pourvue d'une pointe 26 dirigée vers la surface active 4 de la dalle tactile 3 et permettant de créer le point d'impact sur la surface active 4 générant l'onde de choc lors du basculement.

Des inscriptions, non représentées, sont avantageusement prévues par exemple sur la face supérieure du bouton 8, afin de renseigner l'utilisateur sur la correspondance existant entre le sens de rotation du bouton et la variation du contrôle et/ou de la commande conjuguée.

## Revendications

1. Dispositif de contrôle et/ou de commande d'un ou de plusieurs équipements d'un véhicule automobile, **caractérisé en ce qu'**il comprend une dalle tactile (3) pourvue d'une surface active (4), dotée d'au moins un capteur (6) relié à une unité de traitement électronique (7) de manière à localiser la provenance d'une onde acoustique à laquelle est soumise une zone (24,25) de la surface active (4) et à contrôler et/ou commander l'équipement (2) associé à ladite zone (24,25), et **en ce qu'**il comprend au moins un bouton de contrôle et/ou de commande (8) de l'un des équipements (2), pourvu d'une molette (9) montée à rotation autour d'un axe (11) suivant au moins un sens déterminé, et comprenant des dents (12) agissant lors d'une rotation de la molette (9) dans ce sens sur une tête (13) d'un balancier (14) à au moins un bras (16a,16b) solidaire de la tête (13), de manière à faire basculer le balancier (14), à chaque passage d'une dent (12) sur la tête (13), d'une position espacée du bras (16a, 16b) de la surface active (4) de la dalle tactile (3) à une position de percussion de l'extrémité libre du bras (16a,16b) sur la surface active (4) pour générer la propagation d'une onde à partir du point d'impact de l'extrémité libre du bras (16a,16b) sur cette surface (4).

2. Dispositif selon la revendication 1, **caractérisé en ce que** le balancier (14) comprend deux bras (16a, 16b), solidaires de part et d'autre de la tête (13) en prolongement l'un de l'autre, en étant espacés de la surface active de la dalle, et **en ce que** la molette (9) est montée à rotation suivant deux sens opposés de façon que les dents (12) de la molette (9) agissent sur la tête (13) du basculeur (14) pour faire basculer l'un ou l'autre des deux bras (16a,16b) selon le sens de rotation de la molette (9) et amener le bras (16a, 16b) à percuter par son extrémité libre la surface active (4) de la dalle (3).

3. Dispositif selon l'une des revendications 1 ou 2, **caractérisé en ce que** le balancier (14) est monté pivotant autour d'un axe (15) sensiblement parallèle à la surface active (4) de la dalle tactile (3).

4. Dispositif selon l'une quelconque des revendications 1 à 3, **caractérisé en ce que** l'axe de rotation (11) de la molette (9) est sensiblement perpendiculaire à la surface active (4) de la dalle tactile (3), et **en ce que** la molette (9) est un corps cylindrique creux dont le bord situé en regard de la tête (13) du balancier (14) est découpé de manière à définir les dents (12) contactant la tête (13) du balancier (14).

5. Dispositif selon la revendication 4, **caractérisé en ce que** la tête (13) du balancier (14) est en forme de prisme à deux faces situées en regard des dents (12) de la molette (9), inclinées et convergeant vers ces dents (12) de façon que le sommet (23) réunissant ces faces puisse se loger en partie entre deux dents (12) consécutives lors de la rotation de la molette (9).

6. Dispositif selon l'une des revendications précédentes, **caractérisé en ce que** chaque bras (16a, 16b) comporte à son extrémité libre une partie en forme de pointe (26) dirigée vers la surface active (4) de la dalle tactile (3).

7. Dispositif selon l'une quelconque des revendications 1 à 6, **caractérisé en ce que** le bouton de contrôle et/ou de commande (8) comprend en outre une touche de préhension (10) fixée coaxialement à une extrémité d'une tige (18), dont l'extrémité opposée est fixée coaxialement à la molette (9), de manière que la touche (10) et la molette (9) puissent tourner ensemble.
